# EUROPÄISCHE PATENTSCHRIFT

(11) **EP 2 041 434 B1**
(45) Veröffentlichungstag und Bekanntmachung des Hinweises auf die Patenterteilung: **01.02.2012**
(21) Anmeldenummer: 07787069.9
(22) Anmeldetag: 04.07.2007
(51) Int. Cl.: F04B 37/02, F04B 37/08, H01J 7/18

(54) **GETTERPUMPE UND VAKUUMBESCHICHTUNGSANLAGE MIT EINER GETTERPUMPE**
GETTER PUMP AND VACUUM COATING INSTALLATION COMPRISING A GETTER PUMP
POMPE GETTER, ET INSTALLATION D'APPLICATION DE REVÊTEMENT SOUS VIDE ÉQUIPÉE DE CETTE POMPE GETTER

(30) Priorität: 05.07.2006 DE 102006031440
(43) Veröffentlichungstag der Anmeldung: 01.04.2009
(73) Patentinhaber: Von Ardenne Anlagentechnik Gmbh, 01324 Dresden (DE)
(72) Erfinder: MILDE, Falk, 01109 Dresden (DE); HECHT, Hans-Christian, 01689 Weinboehla (DE); BRUECKNER, Joern, 09603 Grossschirma (DE)
(74) Vertreter: Lippert, Stachow & Partner
(86) Internationale Anmeldenummer: PCT/EP2007/056773
(87) Internationale Veröffentlichungsnummer: WO 2008/003724

(56) Entgegenhaltungen:
- JP-A- 60 222 572
- JP-A- 2001 234 326
- US-A- 3 662 522
- US-A- 5 980 213

## Beschreibung

Die Erfindung betrifft eine Getterpumpe, insbesondere zur Verwendung innerhalb der Vakuumkammer einer Vakuumbeschichtungsanlage gemäß Oberbegriff des Anspruchs 1 sowie eine Vakuumbeschichtungsanlage mit einer derartigen Getterpumpe gemäß Oberbegriff des Anspruchs 11.

Ein Getter ist ein chemisch reaktives Material, das dazu dient, ein Vakuum möglichst lange zu erhalten oder auch zu erzeugen. An der Oberfläche eines Getters gehen Gasmoleküle mit den Atomen des Gettermaterials eine Verbindung ein. Auf diese Weise werden Gasmoleküle eingefangen. Man verwendet dieses Prinzip beispielsweise, um im Vakuum verbliebene Restgase zu binden. Das Gas scheidet sich an frischen, unbedeckten Oberflächen ab. Wird die Schicht durch Aufdampfen eines Metalls gebildet, so spricht man von Getterpumpen. In den Getterpumpen der Vakuumtechnik wird meist Titan verwendet. Platin eignet sich ebenfalls.

In Vakuumbeschichtungsanlagen zur Abscheidung von Wechselschichtsystemen aus chemischen Verbindungen, oft Oxiden, und Metallen und gleichzeitiger Schichtabscheidung ist eine sehr effektive Gasabtrennung oder Separation der Prozessgasatmosphären der verschiedenen Beschichtungsprozesse nötig. Wird diese oft als Gasseparation bezeichnete Trennung nicht vorgesehen, so kommt es zu einer deutlichen Degradation der Eigenschaften der Metallschichten.

Typische Anwendungsfälle sind die Herstellung von hochreflektierenden Spiegeln, die Abscheidung von Wechselschichtsystemen aus oxidischen, nitridischen und metallischen Schichten zur Realisierung von Wärmeschutzfunktionen sowie die Herstellung von Cermet-Schichten. Cermets (zusammengesetzt aus engl. ceramic und metal) sind Verbundwerkstoffe aus keramischen Werkstoffen in einer metallischen Matrix (Bindemittel). Sie zeichnen sich durch eine besonders hohe Härte und Verschleißfestigkeit aus.

Gasseparationseinrichtungen bestehen typischerweise aus einer Kombination von Strömungswiderständen und Pumpen. Für höhere Anforderungen an den Grad der Trennung werden differentiell gepumpte Separationsstufen verwendet. Typischerweise kommen Turbomolekularpumpen oder Diffusionspumpen zum Einsatz.

Für die Strömungswiderstände gelten aus technischer Sicht geometrische Limits, so dass die einzelnen Leitwerte nicht beliebig klein eingestellt werden können. Ein hoher Grad an Separation erfordert damit eine sehr hohe Saugleistung für die reaktiven Prozessgase. Hier ergeben sich einerseits ebenfalls geometrische und andererseits kostenmäßige Limitierungen.

Ein sehr effektiver Typ zum Saugen von Reaktivgasen sind so genannte Getterpumpen. In einem Glimmentladungsprozess werden Metallelektroden zerstäubt. Die frisch abgeschiedenen Metallschichten adsorbieren, d.h. gettern auftreffende Reaktivgaspartikel und wirken damit als Pumpe. Da ständig neues Material aufgestäubt wird, lässt sich dieser Prozess kontinuierlich aufrechterhalten. Getterpumpen können im Grenzfall eine flächenbezogene Saugleistung erzielen, welche dem Leitwert einer Blendenöffnung im Molekularströmungsbereich entspricht. Dies gilt allerdings nur denn, wenn die Getterfläche dem Gasstrom unmittelbar zugewandt ist.

Bei konventionell aufgebauten Systemen ist dies jedoch nicht der Fall. Grund dafür ist, dass die zu beschichtenden Substrate vor der Abscheidung des zur Sorption genutzten Metalldampfs im Regelfall geschützt werden sollen. Beispiele für derartige Systeme sind die aus JP 2001/234326 und aus US 5,980,213 bekannten Vorrichtungen. Ein Nachteil konventioneller Einrichtungen ist der nur indirekte Zugang des Reaktivgases zu den Getterflächen, der die Effizienz einer solchen Einrichtung limitiert.

Aus JP 7138739 ist eine Vorrichtung bekannt, bei der eine Beschichtungskammer 1 und eine Verdampfungskammer 2 durch ein Ventil 8 miteinander verbunden sind. In der Beschichtungskammer 1 ist das zu beschichtende Substrat 5 angeordnet. Die Verdampfungskammer 2 ist durch eine Blende 10 in zwei miteinander in Verbindung stehende Teilkammern unterteilt. In der einen Teilkammer ist eine erste Dampfquelle 3 zur Beschichtung des Substrats 5 und in der anderen Teilkammer eine zweite Dampfquelle 4 zur Verdampfung des Gettermaterials angeordnet. Bei dieser Vorrichtung kann nicht verhindert werden, dass sich Gettermaterial auf dem Substrat niederschlägt.

Zur Lösung dieses Problems wird in JP 5001664 vorgeschlagen, eine Getterpumpe 4 mit einem Getterpumpengehäuse 5 so an einer Öffnung der Wandlung 13 einer Vakuumkammer 1 anzuordnen, dass ein Rotor 6 teilweise in das Getterpumpengehäuse 5 und teilweise in die Vakuumkammer 1 ragt. Im Getterpumpengehäuse 5 ist eine Titankugel 8 angeordnet, die nach und nach zerstäubt wird. Das von der Titankugel 8 abgestäubte Gettermaterial schlägt sich auf dem Rotor 6 nieder, d.h der Rotor 6 dient lediglich als Träger für das Gettermaterial. Durch die Rotation des Rotors 6 wird die auf ihm abgeschiedene Schicht von Gettermaterial in die Vakuumkammer 1 hinein bewegt. Ein Nachteil dieser Lösung besteht darin, dass der Rotor 6 nach einer gewissen Betriebszeit ausgewechselt werden muss, da die abgeschiedene Schicht immer dicker wird. Hierdurch entstehen kostenverursachende Stillstandszeiten. Außerdem besteht die Gefahr, dass Gettermaterial zwischen dem Rotor 6 und der Öffnung der Wandlung 13 der Vakuumkammer 1 hindurch in die Vakuumkammer 1 eindringt und auf diese Weise das Substrat verunreinigt, da das von der Titankugel 8 abgestäubte Material in diese Richtung emittiert wird.

Ausgehend von diesem Stand der Technik besteht eine Aufgabe der vorliegenden Erfindung darin, eine Getterpumpe anzugeben, die einen hohen Wirkungsgrad aufweist und einen geringen Wartungsbedarf hat. Eine weitere Aufgabe der Erfindung besteht darin, eine Vakuumbeschichtungsanlage anzugeben, in deren Vakuumkammer ein Ultrahochvakuum erzeugbar ist, wobei das zu beschichtende Substrat nicht durch abgestäubtes Gettermaterial verunreinigt wird.

Erfindungsgemäß werden diese Aufgaben gelöst durch eine Getterpumpe mit den Merkmalen des Anspruchs 1 sowie eine Vakuumbeschichtungsanlage mit den Merkmalen des Anspruchs 11. vorteilhafte Ausgestaltungen und Weiterbildungen der Erfindung sind Gegenstand der abhängigen Ansprüche.

Die erfindungsgemäße Getterpumpe, die insbesondere zur Verwendung innerhalb der Vakuumkammer einer Vakuumbeschichtungsanlage geeignet ist, umfasst ein Getterpumpengehäuse mit einer Expositionsöffnung und in dem Getterpumpengehäuse einen die Expositionsöffnung im wesentlichen verschließenden, relativ zur Expositionsöffnung beweglich angeordneten Getterkörper aus Gettermaterial, wobei ein innerer Teilbereich der Oberfläche des Getterkörpers in das Getterpumpengehäuse hinein weist und ein äußerer Teilbereich der Oberfläche des Getterkörpers durch die Expositionsöffnung aus dem Getterpumpengehäuse hinaus weist und die Positionen des inneren und äußeren Teilbereichs der Oberfläche des Getterkörpers durch Bewegen des Getterkörpers vertauschbar sind, und ist dadurch gekennzeichnet, dass eine Abtrageinrichtung zum Abtrag von Gettermaterial vom inneren Teilbereich der Oberfläche des Getterkörpers vorgesehen ist.

Bei der erfindungsgemäßen Getterpumpe ist im Gegensatz zum Stand der Technik der Getterkörper, von dem das Gettermaterial abgestäubt wird, vor der Expositionsöffnung positioniert, so dass bis auf einen geringen Spalt keine Verbindung zwischen dem Innern des Getterpumpengehäuses und der Umgebung vorhanden ist. Mit anderen Worten: der die Expositionsöffnung im Wesentlichen verschließende Körper besteht selbst aus Gettermaterial. Die Abstäubung von Gettermaterial erfolgt vom inneren Teilbereich der Oberfläche des Getterkörpers. Das abgestäubte Gettermaterial wird dadurch in das Innere des Getterpumpengehäuses, d.h. von der Expositionsöffnung weg, emittiert. Das abgestäubte Gettermaterial bindet Gasmoleküle und Verunreinigungen, die unter Umständen durch den Spalt zwischen dem Getterkörper und der Begrenzung der Expositionsöffnung in das Innere des Getterpumpengehäuses gelangt sind.

Durch die Bewegung des Getterkörpers, bei der der innere Teilbereich und der äußere Teilbereich seiner Oberfläche ihre Position tauschen, wird der durch das Abstäuben von Gettermaterial gereinigte innere Teilbereich der Oberfläche zum äußeren Teilbereich der Oberfläche, so dass dieser gereinigte Teilbereich außerhalb des Getterpumpengehäuses liegt und dort zur Adsorption von Gasmolekülen und Verunreinigungen genutzt werden kann. Die Bewegung des Getterkörpers im Sinne dieser Anmeldungen kann dabei beispielsweise darin bestehen, dass ein endloses, flexibles Band aus Gettermaterial oder aus beweglich miteinander verbundenen, starren Segmenten von Gettermaterial oder aus einem flexiblen Trägermaterial, auf dem starre Segmente von Gettermaterial angeordnet sind, um zwei Umlenkwalzen umlaufend transportiert werden. Andere Formen der Bewegung des Getterkörpers sind selbstverständlich von der Erfindung mit umfasst, wobei es lediglich darauf ankommt, dass ein innerer Teilbereich der Oberfläche des Getterkörpers mit einem äußeren Teilbereich der Oberfläche des Getterkörpers seine Position tauscht.

In einer Ausgestaltung der Erfindung ist vorgesehen, dass der Getterkörper drehbar gelagert ist. Hierdurch wird eine Rotation des Getterkörpers ermöglicht, wodurch der apparative Aufwand zur Realisierung der Beweglichkeit des Getterkörpers gering gehalten werden kann.

Insbesondere bei einem drehbar gelagerten Getterkörper ist es vorteilhaft, dass die Oberfläche des Getterkörpers zylindrisch ist. Hierdurch kann der Spalt zwischen dem Getterkörper unter Begrenzung der Expositionsöffnung permanent sehr gering gehalten werden, so dass die Wahrscheinlichkeit, dass Gasmoleküle oder Verunreinigungen in das Getterpumpengehäuse gelangen, sehr gering ist. Darüberhinaus hat ein zylindrischer Getterkörper einen geringen Bauraumbedarf und ein günstiges Verhältnis von Oberfläche und Volumen.

Vorteilhaft ist die Abtrageinrichtung ein im Innern des Getterkörpers angeordnetes Magnetsystem. Einerseits ist es dadurch möglich, das Getterpumpengehäuse klein zu halten und damit für die erfindungsgemäße Getterpumpe eine kompakte Bauform zu erzielen. Andererseits ist dadurch die Abtrageinrichtung selbst vor dem Niederschlag von abgestäubtem Gettermaterial geschützt. Schließlich ermöglicht es diese Ausgestaltung in besonders vorteilhafter Weise, dass das abgestäubte Gettermaterial von der Expositionsöffnung weg emittiert wird.

In einer Weiterbildung der Erfindung ist vorgesehen, dass mindestens eine Wand des Getterpumpengehäuses als sekundäre Getterfläche ausgebildet ist. Dies bedeutet, dass die Wand des Getterpumpengehäuses leitfähig ausgeführt ist und relativ zum Getterkörper auf Anodenpotential liegt, also beispielsweise geerdet ist, wenn der Getterkörper auf negativem Hochspannungspotential liegt, so dass sich das abgestäubte Gettermaterial auf der Wand niederschlägt. Hierdurch entsteht im Innern des Getterpumpengehäuses eine weitere Getterfläche, die Gasmoleküle und Verunreinigungen im Innern des Getterpumpengehäuses bindet.

Vorteilhaft kann vorgesehen sein, dass an mindestens einer Wand des Getterpumpengehäuses mindestens ein sekundäres Getterflächenelement lösbar befestigt ist. Hierdurch kann erreicht werden, dass nicht die Wand des Getterpumpengehäuses beschichtet wird, sondern das abgestäubte Gettermaterial sich auf dem Getterflächenelement niederschlägt. Da das Getterflächenelement lösbar befestigt ist, kann es auf einfache Weise gegen ein neues Getterflächenelement ausgetauscht werden, wenn eine bestimmte Schichtdicke erreicht ist.

Zur Erhöhung der Pumpleistung kann vorgesehen sein, dass mindestens zwei Getterkörper vorgesehen sind. Selbstverständlich ist es auch möglich, eine noch höhere Zahl von Getterkörpern vorzusehen. Gerade die paarweise Anordnung von Getterkörpern bringt jedoch weitere Vorteile mit sich.

So ist in einer Weiterbildung der Erfindung vorgesehen, dass zwei benachbarte Getterkörper mit entgegengesetzter Drehrichtung antreibbar sind. Auf diese Weise sind die aneinander vorbei laufenden Oberflächenbereiche beider Getterkörper stets beide frisch gereinigt oder beide kontaminiert. Demgegenüber würde der Betrieb benachbarter Getterkörper mit gleicher Drehrichtung dazu führen, dass eine frisch gereinigt der Oberfläche des einen Getterkörpers an der kontaminierten Oberfläche des anderen Getterkörpers vorbeigeführt würde. Ein weiterer Vorteil des Betriebs mit entgegengesetzter Drehrichtung ergibt sich daraus, dass der Antrieb wesentlich vereinfacht werden kann.

Beispielsweise kann vorgesehen sein, dass eine gemeinsame Antriebseinrichtung zum Bewegen von mindestens zwei Getterkörpern vorgesehen ist. Für einen Betrieb mit entgegengesetzter Drehrichtung kann dabei eine Koppelung zwischen der Antriebseinrichtung und den beiden Getterkörpern in einfacher Weise dadurch erfolgen, dass die Getterkörper an ihrem einem Ende je ein Zahnrad aufweisen, wobei die beiden Zahnräder miteinander im Eingriff stehen, und die Antriebseinrichtung, beispielsweise ein Elektromotor, der ebenfalls ein Zahnrad aufweist, einen der beiden Getterkörper antreibt.

Ein weiterer Vorteil der paarweisen Verwendung von Getterkörpern hinsichtlich ihres Betriebes lässt sich dadurch erzielen, dass je zwei Getterkörper mit Wechselspannung mit entgegengesetzter Polung betreibbar sind. Einerseits kann dadurch die gesamte Spannungsversorgung der Getterpumpe gegenüber Gleichspannungsbetrieb stark vereinfacht werden, andererseits werden Bogenentladungen, sogenannte Arcs aufgrund der Ablagerung isolierender Schichten auf den Getterkörpern wirksam vermieden.

Die erfindungsgemäße Vakuumbeschichtungsanlage mit einer Vakuumkammer umfasst mindestens eine Getterpumpe der oben beschriebenen Art. Die Verwendung der erfindungsgemäßen Getterpumpe in einer Vakuumbeschichtungsanlage ermöglicht es, ein Ultrahochvakuum zu erzeugen und gleichzeitig die Substrate vor der Beschichtung mit Gettermaterial zu schützen.

Vorteilhaft ist die Getterpumpe an oder in der Vakuumkammer so angeordnet, dass der äußere Teilbereich der Oberfläche des Getterkörpers in das Innere der Vakuumkammer weist. Mit anderen Worten: die erfindungsgemäße Getterpumpe kann als Ganzes innerhalb der Vakuumkammer montiert sein. Alternativ ist es möglich, in der Wand der Vakuumkammer eine Expositionsöffnung vorzusehen, über der das Getterpumpengehäuse Vakuum dicht mit der Wand der Vakuumkammer verbunden ist. Letztere Variante hat den Vorteil, dass die Getterpumpe von außen zugänglich und somit leichter zu warten ist.

In besonders vorteilhafter Weise lässt sich die erfindungsgemäße Getterpumpe in einer Vakuumbeschichtungsanlage zur Gasseparation verwenden, bei der die Vakuumkammer mindestens zwei aufeinanderfolgend angeordnete Prozesskammern zur Durchführung verschiedener technologischer Schritte umfasst, wobei die Prozesskammern miteinander so verbunden sind, dass ein zu beschichtendes Substrat im Betrieb der Vakuumbeschichtungsanlage durch alle Prozesskammern hindurch transportierbar ist, wenn vorgesehen ist, dass die Getterpumpe zwischen zwei aufeinanderfolgend angeordneten Prozesskammern angeordnet ist. Die zwischen zwei Prozesskammern angeordnete Getterpumpe sorgt dafür, dass die in zwei benachbarten Prozesskammern verwendeten Prozessgase, beispielsweise ein Inertgas und ein Reaktivgas, nicht in die jeweils andere Prozesskammer eindringen und den dort ablaufenden Verfahrensschritt stören können. Gasmoleküle, die sich, von der einen Prozesskammer kommend, durch die Verbindung zwischen den Prozesskammern hindurch auf die andere Prozesskammer zu bewegen, werden von der zwischen den Prozesskammern befindlichen Getterpumpe eingefangen.

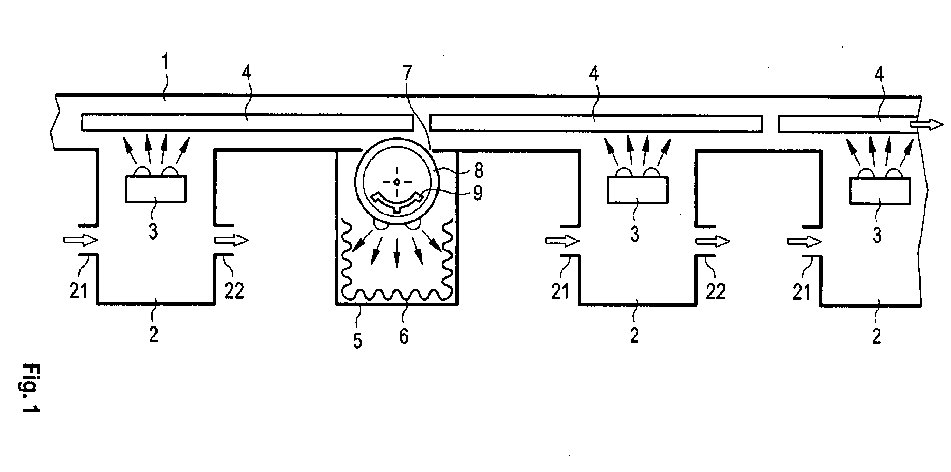

Nachfolgend wird die Erfindung anhand eines Ausführungsbeispiels und einer zugehörigen Zeichnung näher erläutert. Die einzige Figur zeigt beispielhaft einen Längsschnitt durch eine Vakuumbeschichtungsanlage mit mehreren hintereinander angeordneten Prozesskammern.

In der Figur ist eine Vakuumbeschichtungsanlage mit einer Vakuumkammer 1 dargestellt, die mehrere hintereinander angeordnete Prozesskammern 2 aufweist. Die Vakuumbeschichtungsanlage dient der Beschichtung flächiger Substrate 4, beispielsweise Glasscheiben, mit einem so genannten Wechselschichtsystem, d.h. einer mehrlagigen Beschichtung, bei der die unterschiedlichen Lagen aus unterschiedlichen Beschichtungsmaterialien bestehen. Hierfür ist in jeder Prozesskammer 2 eine Beschichtungseinrichtung 3 angeordnet. Im Ausführungsbeispiel sind die Beschichtungseinrichtungen 3 in den Prozesskammern 2 als Magnetrons, d.h. als eine Kombination aus einem Target, das aus dem Beschichtungsmaterial oder einer Komponente des Beschichtungsmaterials besteht, und einem Magnetsystem gebildet.

Aufgrund der Unterschiedlichkeit der verschiedenen herzustellenden Schichten ist es notwendig, in jede Prozesskammer 2 ein anderes Prozessgas, beispielsweise ein Inertgas oder ein Reaktivgas, einzuspeisen. Hierfür sind an den Prozesskammern 2 Gaseinlässe 21 und Gasauslässe 22 vorgesehen. Da die Prozesskammern 2 untereinander verbunden sind, damit die Substrate 4 nacheinander durch alle Prozesskammern 2 transportiert werden können, besteht die Gefahr, dass das Prozessgas aus einer Prozesskammer 2 in eine benachbarte Prozesskammer 2 gelangt. Um die damit verbundenen negativen Effekte auf die Qualität der Beschichtung zu verhindern, ist im Ausführungsbeispiel zwischen zwei benachbarten Prozesskammern 2 eine erfindungsgemäße Getterpumpe angeordnet, die ein Getterpumpengehäuse 5 mit sekundären Getterflächen 6 und einer Expositionsöffnung 7, einem hohlzylindrischen, drehbar gelagerten Getterkörper 8 aus Gettermaterial sowie als Abtrageinrichtung ein im Innern des Getterkörpers angeordnetes Magnetsystem 9 umfasst, mit einer an den Getterkörper angeschlossenen Stromversorgung zur Erzeugung eines Gasentladungsplasmas, wodurch Gettermaterial vom Getterkörper abgetragen wird.

Das Magnetsystem 9 ist dabei im Innern des Getterkörpers 8 so angeordnet, dass das von ihm ausgehende Magnetfeld dazu führt, dass vom inneren Teilbereich der Oberfläche des Getterkörpers 8, d.h. von dem Teilbereich, der sich im Innern des Getterpumpengehäuses 5 befindet, Gettermaterial abgestäubt und von der Expositionsöffnung 7 des Getterpumpengehäuses 5 weg emittiert wird. Durch das Abstäuben von Gettermaterial vom inneren Teilbereich des Getterkörpers 8 wird permanent eine gereinigte Oberfläche zur Verfügung gestellt, die ausschließlich aus atomarem Gettermaterial besteht und die durch Drehung des Getterkörpers 8 mittels einer nicht dargestellten Antriebseinrichtung aus dem Getterpumpengehäuse 5 hinaus, das heißt in die Vakuumkammer 1 hinein bewegt wird.

Der Betrieb der erfindungsgemäßen Getterpumpe hat zwei Effekte: Erstens bindet die frische, gereinigte Oberfläche, wenn sie durch Drehung des Getterkörpers 8 zu einem äußeren Teilbereich der Oberfläche des Getterkörpers 8 wird, Gasmoleküle und Verunreinigungen, die sich in der Vakuumkammer 1 im Bereich der Substrate 4 befinden. Auf diese Weise erfüllt die Getterpumpe die Aufgabe, zwischen zwei benachbarten Prozesskammern 2 eine Gasseparation vorzunehmen. Zweitens binden sowohl die Wolke abgestäubten Gettermaterials innerhalb des Getterpumpengehäuses 5 als auch die ebenfalls dort befindlichen sekundären Getterflächen 6 Gasmoleküle, die durch den Spalt zwischen dem Getterkörper 8 und der Expositionsöffnung 7 in das Innere des Getterpumpengehäuses 5 gelangt sind.

Im beschriebenen Ausführungsbeispiel ist das Kernstück der Getterpumpe sehr ähnlich zu Sputterquellen, von denen Material abgestäubt wird, um ein Substrat zu beschichten. Bei dieser Sputterquelle handelt es sich um eine Zerstäubungsquelle mit rohrförmigem Target, wobei die Zone der Zerstäubung durch die Orientierung eines internen Magnetsystems beeinflusst wird. Im Gegensatz zum Einsatz einer konventionellen Sputterquelle erfolgt die Orientierung des Dampfstromes jedoch vom Substrat weggerichtet.

Dieses Prinzip ermöglicht die Erzeugung einer frischen Metalloberfläche im Zerstäubungsbereich auf dem Target, welcher vom durch den Separationsspalt, das heißt durch den zwei benachbarte Prozesskammern verbindenden Tunnel, laufenden Substrat abgewandt ist. Eine kontinuierliche Rotation dieser frischen Oberfläche in den Separationsspalt sorgt für einen direkten Zugang des Gasstromes zur Getterfläche, ohne dass dabei eine Beschichtung der im Kanal laufenden Substrate bewirkt wird.

Zur Erhöhung der Effektivität der Anordnung sind sekundäre Getterflächen 6 gegenüber dem Racetrack, d.h. gegenüber dem inneren Teilbereich der Oberfläche des Getterkörpers 8, von dem augenblicklich Gettermaterial abgetragen wird, vorgesehen. An diesen sekundären Getterflächen 6 werden diejenigen Gasmoleküle angelagert, welche in den geometrischen Spalt zwischen Targetrohr und Strömungsleitblechen, das heißt zwischen Getterkörper 8 und Expositionsöffnung 7, eintreten.

Die Saugleistung der Getterpumpe wird dadurch eingestellt, dass eine definierte elektrische Leistung in die Magnetronentladung eingespeist wird. Damit ist es möglich, die Saugleistung den Erfordernissen der Prozessführung in der Beschichtungsanlage anzupassen.

Damit die Getterpumpe über den gesamten, in PVD-Anlagen typischerweise vorkommenden Druckbereich einsetzbar ist, wird das Magnetsystem 9 so ausgeführt, dass es ein Magnetfeld mit einer Horizontalkomponente von ca. 60-70 mT (im Maximum) an der Oberfläche des Getterkörpers 8 erzeugt.

Die Anwendung des Rohrmagnetron-Prinzips führt zu einer außerordentlich hohen Standzeit des Getterkörpers 8 der Getterpumpe. Vorzugsweise kommt für das Zerstäubungstargets ein Material zum Einsatz, welches eine niedrige Sputterrate hat. Derartige Materialien sind beispielsweise Titan und Zirkonium.

Durch den Einsatz der beschriebenen Getterpumpe in Vakuumbeschichtungsanlagen wird der Parallelbetrieb von Prozessen ermöglicht, die bisher nur in getakteten oder durch Ventilkammern getrennten Prozesskammern 2 derartiger Anlagen möglich waren.

### Bezugszeichenliste

- 1: Vakuumkammer
- 2: Prozesskammer
- 21: Gaseinlass
- 22: Gasauslass
- 3: Beschichtungseinrichtung
- 4: Substrat
- 5: Getterpumpengehäuse
- 6: sekundäre Getterfläche
- 7: Expositionsöffnung
- 8: Getterkörper
- 9: Magnetsystem

## Patentansprüche

1. Getterpumpe, insbesondere zur Verwendung innerhalb der Vakuumkammer (1) einer Vakuumbeschichtungsanlage, umfassend ein Getterpumpengehäuse (5) mit einer Expositionsöffnung (7) und in dem Getterpumpengehäuse (5) ein die Expositionsöffnung (7) im wesentlichen verschließender, relativ zur Expositionsöffnung (7) beweglich angeordneter Getterkörper (8) aus Gettermaterial, wobei ein innerer Teilbereich der Oberfläche des Getterkörpers (8) in das Getterpumpengehäuse (5) hinein weist und ein äußerer Teilbereich der Oberfläche des Getterkörpers (8) durch die Expositionsöffnung (7) aus dem Getterpumpengehäuse (5) hinaus weist und die Positionen des inneren und äußeren Teilbereichs der Oberfläche des Getterkörpers (8) durch Bewegen des Getterkörpers (8) vertauschbar sind, **dadurch gekennzeichnet, dass** eine Abtrageinrichtung (9) zum Abtrag von Gettermaterial vom inneren Teilbereich der Oberfläche des Getterkörpers (8) vorgesehen ist.

2. Getterpumpe nach Anspruch 1, **dadurch gekennzeichnet, dass** der Getterkörper (8) drehbar gelagert ist.

3. Getterpumpe nach Anspruch 1 oder 2, **dadurch gekennzeichnet, dass** die Oberfläche des Getterkörpers (8) zylindrisch ist.

4. Getterpumpe nach einem der Ansprüche 1 bis 3, **dadurch gekennzeichnet, dass** die Abtrageinrichtung (9) ein im Innern des Getterkörpers (8) angeordnetes Magnetsystem, sowie eine an den Getterkörper (8) angeschlossene Stromversorgungseinrichtung zur Zündung eines Gasentladungsplasmas umfasst.

5. Getterpumpe nach einem der Ansprüche 1 bis 4, **dadurch gekennzeichnet, dass** mindestens eine Wand des Getterpumpengehäuses (5) als sekundäre Getterfläche (6) ausgebildet ist.

6. Getterpumpe nach einem der Ansprüche 1 bis 5, **dadurch gekennzeichnet, dass** an mindestens einer Wand des Getterpumpengehäuses (5) mindestens ein sekundäres Getterflächenelement (6) lösbar befestigt ist.

7. Getterpumpe nach einem der Ansprüche 1 bis 6, **dadurch gekennzeichnet, dass** mindestens zwei Getterkörper (8) vorgesehen sind.

8. Getterpumpe nach Anspruch 7, **dadurch gekennzeichnet, dass** zwei benachbarte Getterkörper (8) mit entgegengesetzter Drehrichtung antreibbar sind.

9. Getterpumpe nach Anspruch 7 oder 8, **dadurch gekennzeichnet, dass** eine gemeinsame Antriebseinrichtung zum Bewegen von mindestens zwei Getterkörpern (8) vorgesehen ist.

10. Getterpumpe nach einem der Ansprüche 7 bis 9, **dadurch gekennzeichnet, dass** je zwei Getterkörper (8) mit Wechselspannung mit entgegengesetzter Polung betreibbar sind.

11. Vakuumbeschichtungsanlage mit einer Vakuumkammer, umfassend mindestens eine Getterpumpe nach einem der Ansprüche 1 bis 10.

12. Vakuumbeschichtungsanlage nach Anspruch 11, **dadurch gekennzeichnet, dass** die Getterpumpe so angeordnet ist, dass der äußere Teilbereich der Oberfläche des Getterkörpers (8) in das Innere der Vakuumkammer (1) weist.

13. Vakuumbeschichtungsanlage nach Anspruch 11 oder 12, **dadurch gekennzeichnet dass** die Vakuumkammer (1) mindestens zwei aufeinanderfolgend angeordnete Prozesskammern (2) zur Durchführung verschiedener technologischer Schritte umfasst, wobei die Prozesskammern (2) miteinander so verbunden sind, dass ein zu beschichtendes Substrat (4) im Betrieb der Vakuumbeschichtungsanlage durch alle Prozesskammern (2) hindurch transportierbar ist, **dadurch gekennzeichnet, dass** die Getterpumpe zwischen zwei aufeinanderfolgend angeordneten Prozesskammern (2) angeordnet ist.

## Claims

1. Getter pump, in particular for use within the vacuum chamber (1) of a vacuum coating installation, comprising a getter pump housing (5) with an exposure opening (7) and, in the getter pump housing (5), a getter body (8), which substantially closes the exposure opening (7), is arranged such that it can move in relation to the exposure opening (7) and is made of getter material, wherein an inner partial region of the surface of the getter body (8) points into the getter pump housing (5) and an outer partial region of the surface of the getter body (8) points through the exposure opening (7) out of the getter pump housing (5), and the positions of the inner and outer partial regions of the surface of the getter body (8) are interchangeable by movement of the getter body (8), **characterized in that** a removal device (9) for removing getter material from the inner partial region of the surface of the getter body (8) is provided.

2. Getter pump according to Claim 1, **characterized in that** the getter body (8) is mounted rotatably.

3. Getter pump according to Claim 1 or 2, **characterized in that** the surface of the getter body (8) is cylindrical.

4. Getter pump according to one of Claims 1 to 3, **characterized in that** the removal device (9) comprises a magnet system, which is arranged in the interior of the getter body (8), and also a power supply device connected to the getter body (8) for igniting a gas discharge plasma.

5. Getter pump according to one of Claims 1 to 4, **characterized in that** at least one wall of the getter pump housing (5) is in the form of a secondary getter surface (6).

6. Getter pump according to one of Claims 1 to 5, **characterized in that** at least one secondary getter surface element (6) is fastened releasably to at least one wall of the getter pump housing (5).

7. Getter pump according to one of Claims 1 to 6, **characterized in that** at least two getter bodies (8) are provided.

8. Getter pump according to Claim 7, **characterized in that** two adjacent getter bodies (8) are drivable in opposite directions of rotation.

9. Getter pump according to Claim 7 or 8, **characterized in that** a common drive device for moving at least two getter bodies (8) is provided.

10. Getter pump according to one of Claims 7 to 9, **characterized in that** in each case two getter bodies (8) can be operated by AC voltage having opposite polarity.

11. Vacuum coating installation having a vacuum chamber, comprising at least one getter pump according to one of Claims 1 to 10.

12. Vacuum coating installation according to Claim 11, **characterized in that** the getter pump is arranged in such a way that the outer partial region of the surface of the getter body (8) points into the interior of the vacuum chamber (1).

13. Vacuum coating installation according to Claim 11 or 12, **characterized in that** the vacuum chamber (1) comprises at least two successively arranged process chambers (2) for carrying out various technological steps, wherein the process chambers (2) are connected to one another in such a way that a substrate (4) to be coated is transportable through all the process chambers (2) during operation of the vacuum coating installation, **characterized in that** the getter pump is arranged between two successively arranged process chambers (2).

## Revendications

1. Pompe de dégazage, en particulier destinée à être utilisée à l'intérieur d'une chambre sous vide (1) d'une installation de revêtement sous vide et comprenant
un boîtier (5) de pompe de dégazage doté d'une ouverture d'exposition (7) et, dans le boîtier (5) de la pompe de dégazage, un corps de dégazage (8) en matériau de dégazage, fermant essentiellement l'ouverture d'exposition (7) et disposé de manière à pouvoir se déplacer par rapport à l'ouverture d'exposition (7),
une partie intérieure de la surface du corps de dégazage (8) étant orientée vers l'intérieur du boîtier (5) de la pompe de dégazage et une partie extérieure de la surface du corps de dégazage (8) étant orientée vers l'extérieur du boîtier (5) de la pompe de dégazage par l'intermédiaire de l'ouverture d'exposition (7),
la position de la partie intérieure et celle de la partie extérieure de la surface du corps de dégazage (8) pouvant être échangées par déplacement du corps de dégazage (8),
**caractérisée en ce que**
elle présente un dispositif d'extraction (9) destiné à extraire le matériau de dégazage de la partie intérieure de la surface du corps de dégazage (8).

2. Pompe de dégazage selon la revendication 1, **caractérisée en ce que** le corps de dégazage (8) est monté à rotation.

3. Pompe de dégazage selon les revendications 1 ou 2, **caractérisée en ce que** la surface du corps de dégazage (8) est cylindrique.

4. Pompe de dégazage selon l'une des revendications 1 à 3, **caractérisée en ce que** le dispositif d'extraction (9) comporte un système magnétique disposé à l'intérieur du corps de dégazage (8) ainsi qu'un dispositif d'alimentation en courant raccordé au corps de dégazage (8) et destiné à allumer un plasma par décharge dans un gaz.

5. Pompe de dégazage selon l'une des revendications 1 à 4, **caractérisée en ce qu'**au moins une paroi du boîtier (5) de la pompe de dégazage est configurée comme surface secondaire de dégazage (6).

6. Pompe de dégazage selon l'une des revendications 1 à 5, **caractérisée en ce qu'**au moins un élément (6) de surface secondaire de dégazage est fixé de manière libérable à au moins une paroi du boîtier (5) de la pompe de dégazage.

7. Pompe de dégazage selon l'une des revendications 1 à 6, **caractérisée en ce qu'**au moins deux corps de dégazage (8) sont prévus.

8. Pompe de dégazage selon la revendication 7, **caractérisée en ce que** deux corps voisins de dégazage (8) peuvent être entraînés dans des sens de rotation opposés.

9. Pompe de dégazage selon les revendications 7 ou 8, **caractérisée en ce qu'**un dispositif commun d'entraînement est prévu pour déplacer au moins deux corps de dégazage (8).

10. Pompe de dégazage selon l'une des revendications 7 à 9, **caractérisée en ce que** deux corps de dégazage (8) peuvent être alimentés en tensions alternatives de polarités opposées.

11. Installation de revêtement sous vide dotée d'une chambre sous vide comprenant au moins une pompe de dégazage selon l'une des revendications 1 à 10.

12. Installation de revêtement sous vide selon la revendication 11, **caractérisée en ce que** la pompe de dégazage est disposée de telle sorte que la partie extérieure de la surface du corps de dégazage (8) soit orientée vers l'intérieur de la chambre sous vide (1).

13. Installation de revêtement sous vide selon les revendications 11 ou 12, **caractérisée en ce que** la chambre sous vide (1) comporte au moins deux chambres de traitement (2) disposées à la suite l'une de l'autre et destinées à exécuter des étapes technologiques différentes, les chambres de traitement (2) étant reliées l'une à l'autre de telle sorte qu'un substrat (4) à revêtir peut être transporté à travers toutes les chambres de traitement (2) lorsque l'installation de revêtement sous vide est en fonctionnement,
**caractérisée en ce que**
la pompe de dégazage est disposée entre deux chambres de traitement (2) disposées à la suite l'une de l'autre.
